# EUROPÄISCHE PATENTSCHRIFT

(11) **EP 1 623 468 B1**
(45) Veröffentlichungstag und Bekanntmachung des Hinweises auf die Patenterteilung: **24.01.2007**
(21) Anmeldenummer: 04721825.0
(22) Anmeldetag: 19.03.2004
(51) Int. Cl.: H01L 41/053, F02M 51/06

(54) **AKTOREINHEIT FÜR EIN PIEZOELEKTRISCH GESTEUERTES KRAFTSTOFFEINSPRITZVENTIL**
ACTUATING UNIT FOR A PIEZO-ELECTRICALLY CONTROLLED FUEL INJECTION VALVE
UNITE ACTIONNEUR POUR SOUPAPE D'INJECTION DE CARBURANT A COMMANDE PIEZO-ELECTRIQUE

(30) Priorität: 02.05.2003 DE 10319601
(43) Veröffentlichungstag der Anmeldung: 08.02.2006
(73) Patentinhaber: ROBERT BOSCH GMBH, 70442 Stuttgart (DE)
(72) Erfinder: BOECKING, Friedrich, 70499 Stuttgart (DE); KIENZLER, Dieter, 71229 Leonberg (DE); UHLMANN, Dietmar, 71404 Korb (DE); BRUETSCH, Uwe, 70174 Stuttgart (DE)
(86) Internationale Anmeldenummer: PCT/DE2004/000569
(87) Internationale Veröffentlichungsnummer: WO 2004/097952

(56) Entgegenhaltungen:
- WO-A-00/08353
- WO-A-99/08330
- WO-A-03/019688
- DE-A- 10 260 363
- DE-A- 10 310 787

## Beschreibung

### Stand der Technik

Die Erfindung betrifft eine Aktoreinheit bestehend aus einem piezoelektrischen Aktor. Solche Aktoreinheiten werden unter anderem bei Kraftstoffeinspritzsystemen und insbesondere in Kraftstoffeinspritzventilen eingesetzt, da die Schaltzeiten solcher Aktoreinheiten sehr kurz sind. Die kurzen Schaltzeiten erlauben einer exaktere Bemessung der eingespritzten Kraftstoffmenge und ermöglichen eine verbesserte Formung des zeitlichen Verlaufs der Einspritzung. Unter dem Sammelbegriff "Kraftstoffeinspritzventil" werden im Zusammenhang mit der Erfindung sämtliche Bauarten von Kraftstoffeinspritzventil, wie zum Beispiel Injektoren für Common-Rail-Einspritzsysteme oder Einspritzdüsen konventioneller Kraftstoffeinspritzanlagen verstanden.
Betätigt wird ein Kraftstoffeinspritzventil mit Piezo-Aktor dadurch, dass der piezoelektrische Aktor mit einer elektrischen Spannung beaufschlagt wird, wodurch sich der piezoelektrische Aktor aufgrund bekannter physikalischer Effekte der Piezokeramik schnell ausdehnt und ein Ventilschließglied von einem Ventilsitz abhebt. Der piezoelektrische Aktor hat eine gewisse Masse, die dabei beschleunigt wird. Wird die an den Aktor angelegte Spannung reduziert, hat der Aktor das Bestreben, sich zusammenzuziehen. Aufgrund der Massenträgheit der zuvor beschleunigten Masse des Aktors entstehen dadurch in Abhängigkeit der Ansteuergeschwindigkeit Zugkräfte im Aktor, die zu Beschädigungen des piezoelektrischen Aktors, insbesondere zu Rissen in den Lötverbindungen zwischen den einzelnen Schichten des piezoelektrischen Aktors, führen. Um derartige Beschädigungen zu vermeiden, ist man dazu übergegangen, den piezoelektrischen Aktor mittels eines als Feder ausgebildeten zylindrischen Hohlkörpers in axialer Richtung vorzuspannen. Eine solche Anordnung ist beispielsweise aus der WO 00/08353 (Siemens) bekannt. Dieser Hohlkörper ist aus einem ebenen Blech gebogen und wird an der dabei entstehenden ersten Fuge verschweißt. Die erste Fuge'verläuft dabei parallel zur Längsachse des Hohlkörpers.

Das Verschweißen der ersten Fuge hat unter anderem folgende Nachteile: Das Schweißen verursacht eine in der Regel unerwünschte Gefügeveränderung des Hohlkörpers in unmittelbarer Nähe der Schweißnaht. Ein zweites Problem sind die beim Schweißen entstehenden Schweißspritzer, welche Schwierigkeiten bei der Montage der Aktoreinheit mit sich bringen können oder sogar zu Funktionsausfällen des Kraftstoffeinspritzventils führen können, wenn sich während des Betriebs einer oder mehrere Schweißspritzer lösen. Ein drittes Problem ist das Einsinken der Schweißnaht (Nahteinfall) an Beginn und Ende der Schweißnaht und die daraus resultierende Kerbwirkung und Spannungserhöhung.

### Vorteile der Erfindung

Bei der erfindungsgemäßen Aktoreinheit mit einem in einem Hohlkörper angeordneten piezoelektrischen Aktor, wobei der Hohlkörper elastisch ausgebildet ist und den Aktor vorspannt, und wobei der Hohlkörper mit Ausnehmungen versehen ist und eine parallel zu einer Längsachse verlaufende erste Fuge aufweist, ist erfindungsgemäß vorgesehen, dass mindestens an einem ersten Ende des Hohlkörpers eine der ersten Fuge gegenüberliegend angeordnete zweite Fuge vorgesehen ist.

Bei der erfindungsgemäßen Ausgestaltung des Hohlkörpers ist es möglich auf das Verschweißen der ersten Fuge zu verzichten. Dadurch entfallen auch die durch das Schweißen verursachten Probleme. Außerdem verringern sich die Herstellungskosten.

Ein Nachteil der Aktoreinheiten mit offener Trennfuge am Hohlkörper ist, dass die Federsteifigkeit des Hohlkörpers in axialer Richtung über den Umfang nicht konstant ist. In der Regel ist die Federsteifigkeit wegen der Ausnehmungen im Hohlkörper im Bereich der Trennfuge reduziert. Im Ergebnis führt dies dazu, dass die obere Abdeckplatte und die untere Abdeckplatte im Betrieb der Aktoreinheit mit seitlichen Kräften beaufschlagt werden. Daraus resultiert eine ungleiche Belastung des piezoelektrischen Aktors mit Kräften und Biegemomenten, die unerwünscht sind.

Durch das erfindungsgemäße Einbringen einer zweiten Fuge in den Hohlkörper, die der ersten Fuge gegenüberliegend angeordnet ist, wird die Federrate des Hohlkörpers an der der ersten Fuge gegenüberliegenden Seite ebenfalls reduziert. Im Ergebnis führt dies dazu, dass die von der oberen Abdeckplatte und der unteren Abdeckplatte in den piezoelektrischen Aktor eingeleitete Vorspannkraft genau in Richtung der Längsachse des piezoelektrischen Aktors wirkt. Solche Belastungen sind sehr günstig für den piezoelektrischen Aktor, so dass die Lebensdauer der mit einem erfindungsgemäßen Hohlkörper ausgerüsteten Aktoreinheiten deutlich gesteigert werden kann.

Die erfindungsgemäßen Vorteile können weiter gesteigert werden, wenn auch an einem zweiten Ende des Hohlkörpers einer der ersten Fuge gegenüberliegend angeordnete zweite Fuge vorgesehen ist. Alternativ kann sich die zweite Fuge auch vom ersten Ende bis zum zweiten Ende des Hohlkörpers erstrecken. In anderen Worten: Der Hohlkörper besteht bei diesem Ausführungsbeispiel aus zwei gleich großen Halbschalen, welche den piezoelektrischen Aktor umschließen. Die Halbschalen dieses Hohlkörpers sind auch fertigungstechnisch sehr günstig.

Alternativ ist es auch möglich, in den Hohlkörper an seinen Enden Aussparungen einzubringen und zwar gegenüber der ersten Fuge. Dadurch wird die Federrate des Hohlkörpers auch an dieser Stelle gezielt verringert, so dass die Federrate des Hohlkörpers rotationssymmetrisch ist und somit die gewünschte axiale Krafteinleitung erreicht wird.

Um die Vorspannkraft von dem Hohlkörper auf den piezoelektrischen Aktor bestmöglich einleiten zu können, empfiehlt es sich, dass der Hohlkörper an seinem ersten Ende mit einer oberen Abdeckplatte oder einer Einstellscheibe und an seinem zweiten Ende mit einer unteren Abdeckplatte oder einem Kopplergehäuse verbunden ist. Diese Verbindungen können beispielsweise durch Schweißen oder Bördeln erfolgen.

Wenn nur eine radiale Fixierung des Hohlkörpers erforderlich ist, kann diese durch eine Ringnut oder einen Absatz in der oberen und/oder der unteren Abdeckplatte oder in der Einstellscheibe und dem Kopplergehäuse erfolgen. Dies kann beispielsweise dann ausreichend sein, wenn der Hohlkörper nicht auf Zug, sondern auf Druck belastet wird. Besonders vorteilhaft an diesen Ausführungsvarianten ist, dass durch die Ringnut und durch den Absatz der Hohlkörper relativ zu dem piezoelektrischen Aktor oder zu dem hydraulischen Koppler zentriert wird. Dieser Effekt kann weiter verbessert werden, wenn Ringnut und Absatz so bemessen werden, dass sie den Hohlkörper bei der Montage geringfügig aufweiten.

Es hat sich als besonders vorteilhaft herausgestellt, wenn die Kontaktierung eines in dem Hohlkörper befindlichen Piezoaktors über die obere Abdeckplatte erfolgt und die obere Abdeckplatte zweiteilig ausgeführt ist, wobei zwischen den zwei Teilen der oberen Abdeckplatte eine Trennfuge vorhanden ist.

Dadurch werden der erforderliche Bauraum für die Aktoreinheit und die Zahl der benötigten Bauteile verringert und außerdem wird die Kontaktierung des piezoelektrischen Aktors, die die Bewegungen des Aktors mindestens teilweise mitmachen muss, von der oberen Abdeckplatte mit übernommen. Dadurch ergibt sich eine einfache und sichere elektrische Kontaktierung des piezoelektrischen Aktors, welche die erforderliche Elastizität aufweist. Außerdem wird durch diese Maßnahme die beim Betrieb des piezoelektrischen Aktors entstehende Wärme sehr gut abgeführt, was die Betriebssicherheit und die Lebensdauer des piezoelektrischen Aktors verbessert.

Es hat sich weiter als vorteilhaft erwiesen, wenn die erste Fuge und die zweite Fuge des Hohlkörpers in die Trennfuge der oberen Abdeckplatte münden, so dass die elektrische Trennung der beiden Teile der oberen Abdeckplatte nicht durch den Hohlkörper, der ja beispielsweise aus Federstahl hergestellt werden kann, aufgehoben wird.

Zusätzlich kann die obere Abdeckplatte durch einen Isolator, insbesondere einen Isolator aus Keramik, elektrisch isoliert werden.

Um den mechanischen Zusammenhalt der zweiteiligen oberen Abdeckplatte zu gewährleisten, kann zusätzlich eine Sicherungsklammer oder ein Sicherungsteil vorgesehen werden, welcher die zweiteilige obere Abdeckplatte zusammenhält.

In weiterer Ergänzung der Erfindung kann vorgesehen sein, dass zwischen dem Hohlkörper und dem Piezoaktor ein flexibles Bindemittel, insbesondere kunststoffgebundenes Metall oder ein weiches Lot vorhanden ist.

Die Ausnehmungen in dem Hohlkörper können die bekannte knochenförmige Form haben und quer zu einer Längsachse des Hohlkörpers verlaufen. Es ist weiter vorteilhaft, wenn mehrere Ausnehmungen in einer Ebene hintereinander angeordnet sind und die Ebene mit der Längsachse des Hohlkörpers einen rechten Winkel bildet. Des Weiteren hat es sich als vorteilhaft erwiesen, wenn eine gerade Zahl von Ausnehmungen in einer Ebene vorhanden ist.

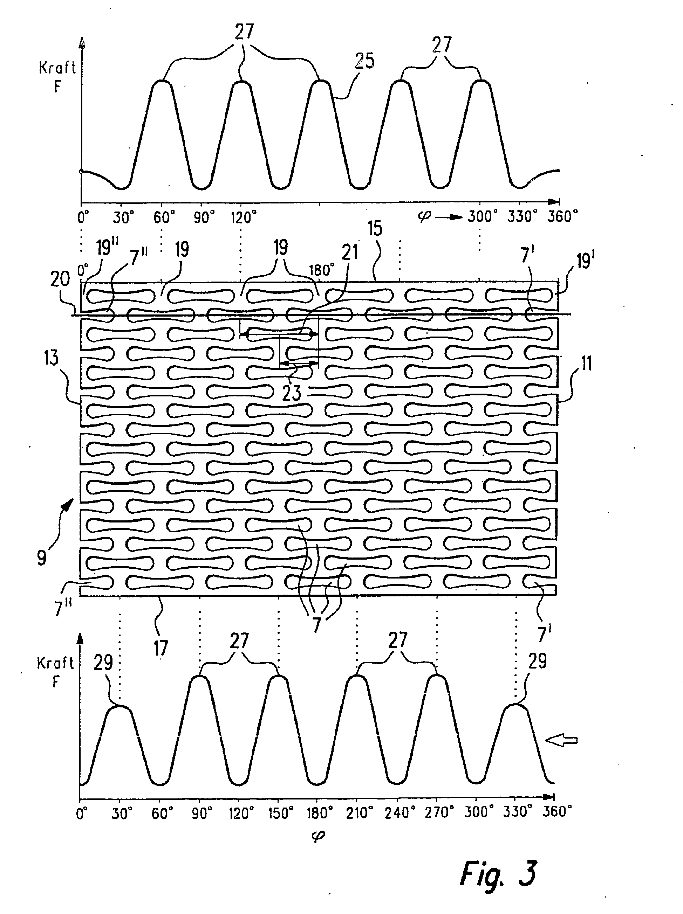

Wenn mehrere Ebenen mit Ausnehmungen im Hohlkörper vorgesehen sind, empfiehlt es sich, dass die Ebenen parallel zueinander verlaufen und die Ausnehmungen zweier benachbarter Ebenen zueinander versetzt angeordnet sind. Dabei ist es besonders vorteilhaft, wenn der Versatz der Ausnehmungen zweier benachbarter Ebenen gleich dem halben Rapport der Ausnehmungen einer Ebene sind. Der Begriff "Rapport" wird weiter unten im Zusammenhang mit der Figur 3 noch ausführlich erläutert.

Bevorzugt hat der Hohlkörper einen Querschnitt in Form eines Kreises oder eines regelmäßigen Vielecks.

Der erfindungsgemäße Hohlkörper kann bei Aktoreinheiten eingesetzt werden, in denen der piezoelektrischer Aktor im Hohlkörper angeordnet ist und bei denen der piezoelektrischer Aktor durch den vorgespannten Hohlkörper auf Druck belastet wird. Dies bedeutet, dass der Hohlkörper selbst auf Zug belastet wird.

Erfindungsgemäß kann weiter vorgesehen sein, dass der Hohlkörper an seinem ersten Ende und/oder an seinem zweiten Ende einen nicht durch Ausnehmungen perforierten Bereich aufweist. Dadurch wird die vom Hohlkörper auf eine Abdeckplatte oder ein anderes Bauteil des Injektors übertragene Federkraft vergleichsmäßigt, da der Hohlkörper im Bereich seiner Enden gezielt versteift wird. Dies bedeutet, dass sich die Maxima der Federkraft über den Umfang des Hohlkörpers verringern und die Problematik der von dem Hohlkörper in den Piezoaktor eingeleiteten Querkräfte weiter entschärft wird.

Weitere Vorteile und vorteilhafte Ausgestaltungen der Erfindung sind der nachfolgenden Zeichnung, deren Beschreibung und den Patentansprüchen entnehmbar.

### Zeichnungen

Es zeigen:
- Figur 1: ein erstes Ausführungsbeispiel einer erfindungsgemäßen Aktoreinheit,
- Figur 2: ein zweites Ausführungsbeispiel einer erfindungsgemäßen Aktoreinheit,
- Figur 3: ein Beispiel für eine Platine aus der ein Hohlkörper gebogen wird,
- Figur 4: ein erstes Ausführungsbeispiel eines Hohlkörpers in einer perspektivischen Darstellung mit einer geraden Anzahl (hier: 16) von Aussparungsreihen in Längsrichtung,
- Figur 5: das erste Ausführungsbeispiel gemäß Figur 4 in einem anderen Blickwinkel,
- Figur 6: ein zweites Ausführungsbeispiel eines erfindungsgemäßen Hohlkörpers schräg von unten,
- Figur 7: ein drittes Ausführungsbeispiel eines erfindungsgemäßen Hohlkörpers mit einer ungeraden Anzahl (hier: 17) von Aussparungsreihen in Längsrichtung,
- Figur 8: ein Beispiel für eine radiale Fixierung des Hohlkörpers an den Abdeckplatten,
- Figur 9: eine Darstellung eines weiteren Ausführungsbeispiels einer erfindungsgemäßen Aktoreinheit im Teillängsschnitt und in einer Schnittdarstellung,
- Figur 10: ein weiteres Ausführungsbeispiel eines erfindungsgemäßen Hohlkörpers und
- Figur 11: eine schematische Darstellung einer Kraftstoffeinspritzanlage.

### Beschreibung der Ausführungsbeispiele

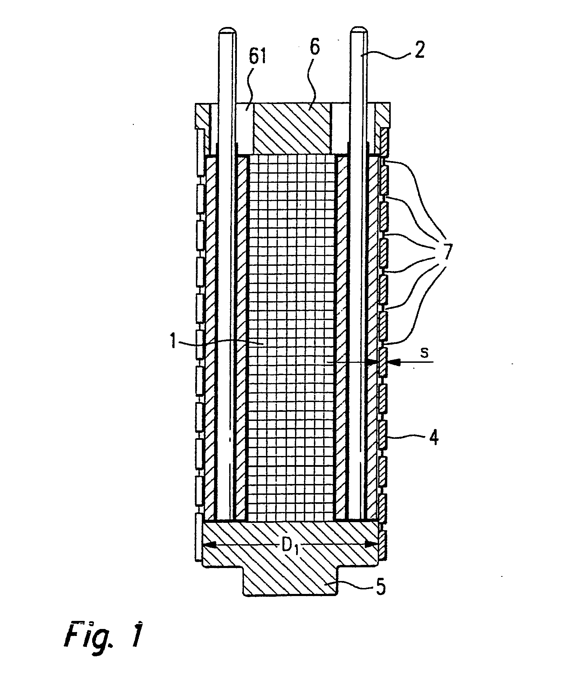

In Figur 1 ist ein erstes Ausführungsbeispiel einer erfindungsgemäßen Aktoreinheit dargestellt. Die Aktoreinheit besteht aus einem piezoelektrischen Aktor 1, der aus mehreren übereinander gestapelten piezoelektrischen Einzelelementen (nicht dargestellt) aufgebaut sein kann. Der piezoelektrische Aktor 1 wird über Kontaktstifte 2 angesteuert, die längs des Aktors 1 angeordnet sind und mit dem Aktor 1 elektrisch leitend verbunden sind. Durch Anlegen einer Spannung zwischen den Kontaktstiften 2 wird eine Längsdehnung des piezoelektrischen Aktors 1 erzeugt, die beispielsweise zum Steuern eines Einspritzventils in einer Brennkraftmaschine eingesetzt werden. Der piezoelektrische Aktor 1 mit den Kontaktstiften 2 ist in einem als Rohrfeder ausgebildeten Hohlkörper 4 angeordnet. Der piezoelektrische Aktor 1 liegt mit seinen Stirnflächen jeweils an einer Abdeckplatte 5, 6 an, wobei die obere Abdeckplatte 6 Durchführungen 61 aufweist, durch die sich die Kontaktstifte 2 erstrecken. Die obere und untere Abdeckplatte 5, 6 sind jeweils form- und/oder kraftschlüssig, vorzugsweise durch Schweißen, mit dem Hohlkörper 4 verbunden. Die Schweißnähte zwischen der oberen und der unteren Abdeckplatte 5, 6 sowie des Hohlkörpers 4 sind in Figur 1 nicht dargestellt. Alternativ kann die Verbindung zwischen dem Hohlkörper und den beiden Abdeckplatten 5, 6 zum Beispiel auch mit Hilfe einer Bördelung erfolgen, wobei die umgebördelten oberen und unteren Randbereiche des Hohlkörpers 4 jeweils in die Abdeckplatten 5, 6 eingreifen (nicht dargestellt).

Der piezoelektrische Aktor 1 wird durch den Hohlkörper 4 und die Abdeckplatten 5, 6 mit einer Vorspannkraft auf Druck beansprucht. D. h. der Hohlkörper 4 wird vor dem Verschweißen mit der oberen und unteren Abdeckplatte 5, 6 vorgespannt und dann verschweißt.

Der Hohlkörper 4 wird vorzugsweise aus Federstahl gefertigt. Um eine gewünschte Federrate bei vorgegebener Wandstärke "s" einstellen zu können, sind in den Hohlkörper 4 eine Vielzahl von Ausnehmungen 7 eingebracht. Aus Gründen der Übersichtlichkeit sind nicht alle Ausnehmungen in Figur 1 mit Bezugszeichen versehen worden. Da sich die vielen Ausnehmungen 7 am besten durch Stanzen herstellen lassen, wird der Hohlkörper 4 in der Regel aus Blech gefertigt. Aus dem Blech wird zunächst eine Platine mit den Ausnehmungen 7 ausgestanzt. Anschließend wird die Platine gebogen, bis sie beispielsweise einen kreisrunden Querschnitt oder einen Querschnitt in Form eines regelmäßigen Vielecks hat. Dort wo die beiden Enden der gebogenen Platine aufeinander treffen, entsteht eine erste Fuge (in Fig. 1 nicht dargestellt).

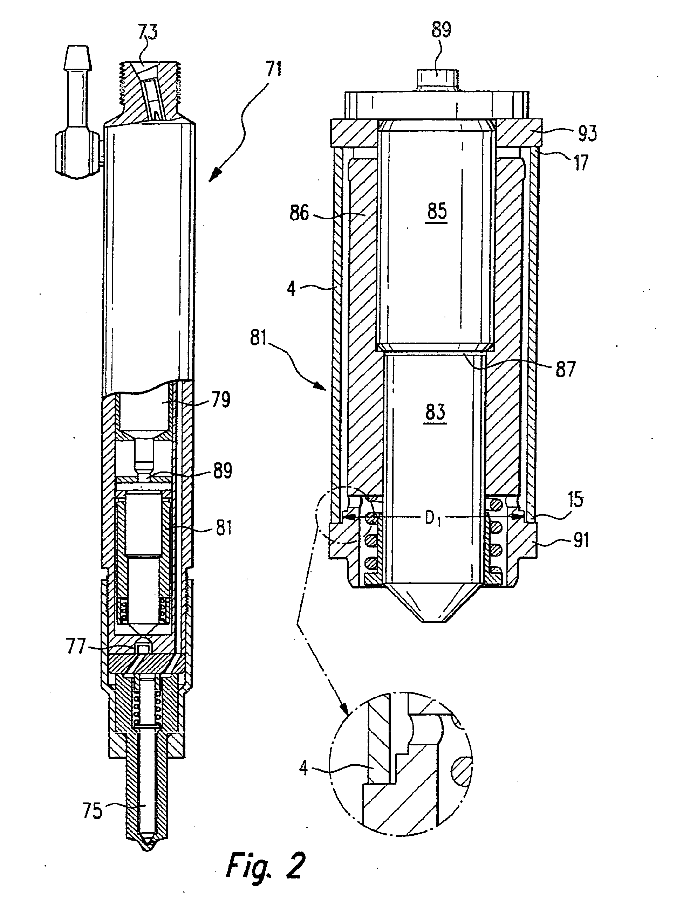

In Figur 2 wird ein zweites Ausführungsbeispiel einer erfindungsgemäßen Aktoreinheit dargestellt, die in einen piezobetätigten Injektor 71 integriert ist.

Da die vorliegende Erfindung im Wesentlichen eine Aktoreinheit und einen dazugehörigen Hohlkörper 4 betrifft, wird der Injektor 71 nicht in allen Details erläutert, sondern im Wesentlichen nur die Anbindung der Aktoreinheit an den Injektor 71 beschrieben. Die übrigen Funktionalitäten des Injektors 71 sind einem Fachmann auf dem Gebiet der Einspritztechnik ohnehin bekannt und bedürfen deshalb keiner näheren Erläuterung.

Der Injektor 71 hat einen Hochdruckanschluss 73. Über den Hochdruckanschluss 73 wird der Injektor 71 mit unter hohem Druck stehenden Kraftstoff (nicht dargestellt) versorgt. Wenn eine Einspritzung in den nicht dargestellten Brennraum einer Brennkraftmaschine erfolgen soll, hebt eine Düsennadel 75 von ihrem nicht dargestellten Sitz ab und gibt ebenfalls nicht dargestellte Spritzlöcher frei. Gesteuert wird die Düsennadel 75 über ein Steuerventil 77, welches über einen piezoelektrischen Aktor 79 betätigt wird. Zwischen dem piezoelektrischer Aktor 79 und dem Steuerventil 77 ist ein hydraulischer Koppler 81 angeordnet, welcher auf der rechten Seite von Figur 2 vergrößert dargestellt ist.

Der hydraulische Koppler 81 besteht im Wesentlichen aus einem Ventilkolben 83 und einem Übersetzerkolben 85, die in einem Kopplergehäuse 86 geführt werden. Zwischen dem Ventilkolben 83 und dem Übersetzerkolben 85 ist ein Kopplerspalt 87 vorhanden, welcher mit Kraftstoff (nicht dargestellt) gefüllt ist. Dieser Kopplerspalt 87 ist unter anderem deswegen notwendig, weil sich die Temperaturausdehnungskoeffizienten des piezoelektrischen Aktors 79 und der metallischen Bauteile des Injektors 71 stark unterscheiden.

Mit seinem Ventilkolben 83 betätigt der hydraulische Koppler 81 das Steuerventil 77, während der Übersetzerkolben 85 mit einem Vorsprung 89 an den piezoelektrischer Aktor 79 anliegt. Der Übersetzerkolben 85 wird über einen erfindungsgemäßen Hohlkörper 4, welcher auf Druck vorgespannt ist, gegen den piezoelektrischer Aktor 79 gepresst, so dass dieser mit einer Druckvorspannung beaufschlagt wird. Dabei stützt sich der Hohlkörper mit seinem ersten Ende 15 gegen einen Absatz 91 des Kopplergehäuses 86 ab. Mit seinem zweiten Ende 17 stützt sich der Hohlkörper 4 gegen eine Einstellscheibe 93 ab. Über die Einstellscheibe 93 wird die Federkraft des Hohlkörpers 4 auf den Vorsprung 89 des Übersetzerkolbens 85 und damit auf den piezoelektrischen Aktor 79 übertragen.

Damit der Hohlkörper 4 konzentrisch zum hydraulischen Koppler 81 und damit auch konzentrisch zum piezoelektrischen Aktor 79 angeordnet ist, ist der Durchmesser D₁ des Absatzes 91 so auf den Innendurchmesser des Hohlkörpers 4 abgestimmt, dass der Hohlkörper 4 leicht aufgeweitet wird, wenn er auf den Absatz 91 aufgeschoben wird. Da der erfindungsgemäße Hohlkörper 4 eine sich über die gesamte Länge des Hohlkörpers 4 erstreckende erste Fuge 31 (nicht dargestellt) aufweist, lässt sich der Hohlkörper 4 relativ leicht so weit aufweiten, dass er auf den Absatz 91 passt.

Wenn, wie bei dem Ausführungsbeispiel gemäß Figur 2, der Hohlkörper 4 mit einer Druckvorspannung beaufschlagt wird, genügt es, wenn dieser sich an seinen Enden 17 und 15 in axialer Richtung abstützen kann, wie dies in Figur 2 dargestellt ist. Um die radiale Fixierung des Hohlkörper 4 weiter zu verbessern, kann in dem Absatz 91 und/oder in der Einstellscheibe 93 alternativ oder zusätzlich eine Ringnut (nicht dargestellt) vorgesehen sein.

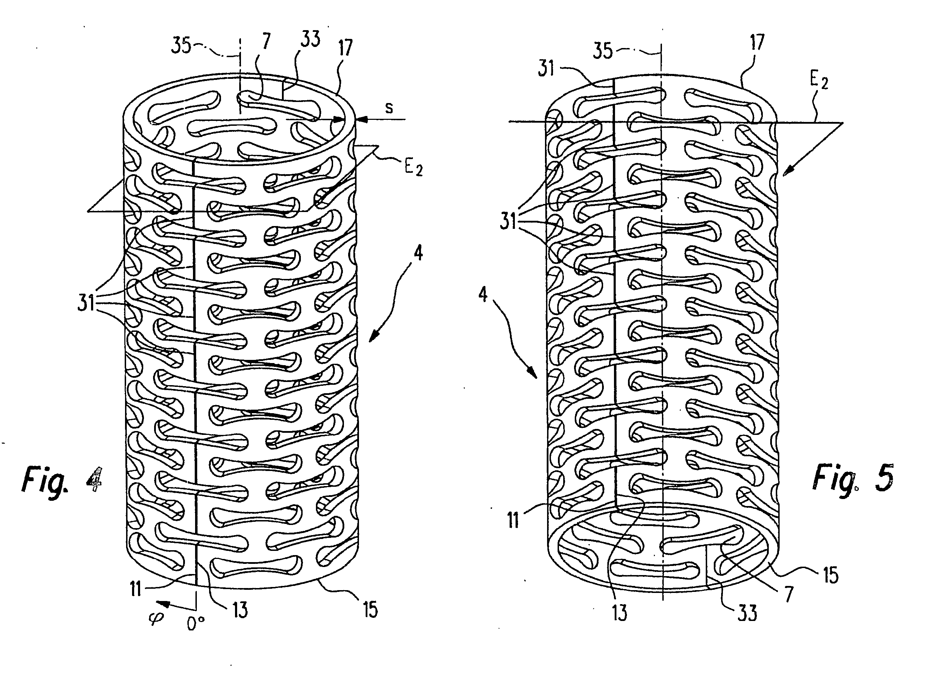

In Figur 3 ist eine Platine 9 dargestellt, aus der ein erfindungsgemäßer Hohlkörper 4 gewickelt werden kann. In der Platine 9 ist eine Vielzahl von Ausnehmungen 7 ausgestanzt. Aus Gründen der Übersichtlichkeit sind nicht alle Ausnehmungen 7, die bei dem in Figur 3 dargestellten Ausführungsbeispiel eine knochenförmige Form haben, mit Bezugszeichen versehen. Die Platine 9 ist rechteckig, wobei zwei einander gegenüberliegende Kanten 11 und 13 der Platine 9 von den Ausnehmungen 7 unterbrochen werden, während die einander gegenüberliegenden Kanten 15 und 17 gerade verlaufen und nicht von den Ausnehmungen 7 unterbrochen werden.
Die Platine 9 wird so zu einem zylindrischen oder vieleckigen Hohlkörper gewickelt, dass die Kanten 15 und 17 das erste Ende 15 und das zweite Ende 17 des Hohlkörpers 4 bilden (siehe Figur 4) bilden. Das heißt, die in Figur 4 und 5 nicht dargestellte Längsachse 35 des Hohlkörpers 4 verläuft parallel zu den Kanten 11 und 13.

Wenn die Platine 9 in der oben genannten Weise zu einem Zylinder oder einem Vieleck gebogen wurde, berühren sich die Kanten 11 und 13 und bilden eine erste Fuge 31 (siehe Fig. 4 und 5), die parallel zur Längsachse 35 des Hohlkörpers 4 verläuft.

In der Platine 9 sind immer mehrere Ausnehmungen 7 in einer Reihe hintereinander angeordnet. Sie werden durch Stege 19 zwischen den Ausnehmungen getrennt. Auch bei den Stegen 19 wurde darauf verzichtet, alle Stege der Platine 9 mit Bezugszeichen zu versehen, um die Übersichtlichkeit nicht zu beeinträchtigen. Wenn die Platine 9 zu einem Hohlkörper in der zuvor beschriebenen Weise gebogen wird, liegen die hintereinander angeordneten Ausnehmungen 7 in einer Ebene. Beispielhaft ist in Figur 3 eine Reihe von Ausnehmungen 7, die hintereinander angeordnet sind, durch eine Linie 20 gekennzeichnet. Bei dem in Figur 3 dargestellten Ausführungsbeispiel einer Platine 9 sind 16 Reihen von sechs Ausnehmungen 7 zwischen der Kante 15 und der Kante 17 angeordnet.

Wie aus Figur 3 ersichtlich, sind die Ausnehmungen 7 zweier benachbarter Reihen versetzt zueinander angeordnet. Dabei ist der Versatz so gewählt, dass er der halben Länge einer Ausnehmung 7 und eines Stegs 19 entspricht. Dieses Maß ist in der Figur 3 exemplarisch für eine Ausnehmung und zwei halbe Stege 19 durch den Doppelpfeil 21 angedeutet. Dieses Maß wird auch als "Rapport" bezeichnet. Der Versatz zwischen den Ausnehmungen 7 zweier benachbarter Reihen von Ausnehmungen ist in Figur 3 mit dem Bezugszeichen 23 bezeichnet.

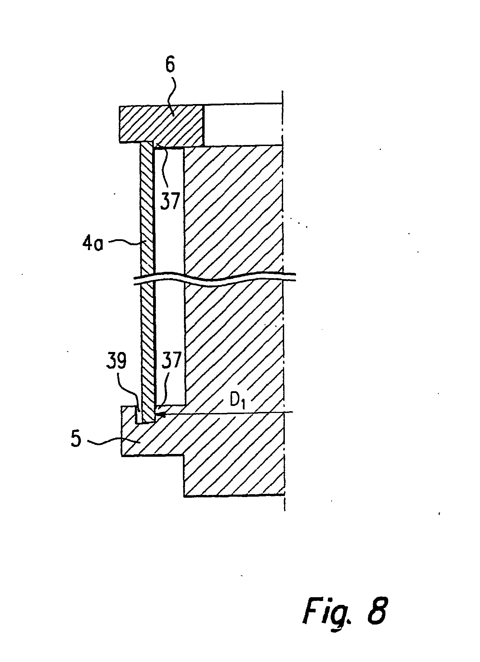

Wenn man die Platine 9 zu einem Hohlkörper 4 (siehe Fig. 4 oder 5) aufrollt und diesen Hohlkörper 4 an seinen Stirnseiten über eine obere Abdeckplatte 5 (siehe Figur 1 und 8) und eine untere Abdeckplatte 6 (siehe Figur 1 und 8) mit einer Druckkraft beaufschlagt, dann hat die zwischen oberer Abdeckplatte 5 und der Kante 15 wirkende Kraft F über den Umfang des Hohlkörpers 4 den durch die Linie 25 qualitativ dargestellten Verlauf. Der Umfangswinkel ϕ beginnt an der Kante 13 mit 0° und endet an der Kante 11 mit 360°.

Es zeigt sich, dass immer dort, wo ein Steg 19 die Kante 15 "abstützt", eine große Kraft F, angedeutet durch die Maxima 27 der Linie 25, übertragen werden kann. Die einzige Ausnahme existiert dort, wo die Kanten 11 und 13 aneinander stoßen. Dort schwächt die "durchgeschnittene" Ausnehmung 7 mit ihren Teilen 7' und 7" die Struktur der Platine 9, so dass die an dieser Stelle zwischen oberer Abdeckplatte 5 und Hohlkörper 4 übertragene Kraft F geringer ist. Dieser Sachverhalt ist in Figur 3 durch den im Vergleich mit den Maxima 27 deutlich geringeren Wert für die Kraft F, bei ϕ = 0° und bei ϕ = 360° dargestellt.

Ähnlich verhält es sich an der Kante 17. Wie aus Figur 3 ersichtlich, befindet sich in unmittelbarer Nähe der Kante 17 bei ϕ = 0° und 360° eine angeschnittene Ausnehmung, bestehend aus den Teilen 7' und 7'', während sich in unmittelbarer Nähe der Kante 15 bei ϕ = 0° und 360°ein aufgetrennter Steg 19 mit den Hälften 19' und 19'' befindet. Daraus ergibt sich ein etwas anderer Kräfteverlauf über den Umfang der Kante 17.

Es gibt dort, wie aus dem unteren F-ϕ-Diagramm in Figur 3 ersichtlich, vier Maxima 27 und zwei weitere lokale Maxima 29 in der Nähe der Kante 11 und 13 bei den Winkeln ϕ = 30° und 330°, die deutlich kleiner als die Maxima 27 sind.

Wegen dieser über den Umfang ungleichen Kraftübertragung zwischen oberer Abdeckplatte 6 und der Kante 15 einerseits sowie der unteren Abdeckplatte 5 und der Kante 17 andererseits wird ein auf die obere Abdeckplatte 6 und die untere Abdeckplatte 5 wirkendes Biegemoment von dem Hohlkörper 4 erzeugt, wenn der Hohlkörper 4 mit einer Vorspannung an der oberen und der unteren Abdeckplatte 6, 5 befestigt wird. Dieses Biegemoment wird naturgemäß auch auf den piezoelektrischen Aktor 1 übertragen, was sich ungünstig auf dessen Betriebssicherheit und Lebensdauer auswirkt. Außerdem ist dieses Biegemoment auch an den von der Aktoreinheit betätigten hydraulischen Ventilgliedern nicht erwünscht.

In Figur 4 ist ein Hohlkörper 4, der aus einer in Fig. 3 dargestellten Platine 9 hergestellt wurde, perspektivisch dargestellt. Die Reihen von Ausnehmungen 7, die in Figur 4 nicht einzeln bezeichnet sind, bilden 16 Ebenen E₁ bis E₁₆, welche senkrecht zur Längsachse 35 des Hohlkörpers 4 verlaufen. Andeutungsweise ist in Fig. 4 zur Veranschaulichung eine Ebene E₂ dargestellt. Ebenso ist in Fig. 4 die Wandstärke s des Hohlkörpers 4 eingezeichnet.

Erfindungsgemäß wird deshalb vorgesehen, an den Kanten 15 und 17 am Winkel ϕ = 180 ° eine zweite Fuge 33 vorzusehen. Diese zweite Fuge 33 wird nachfolgend anhand der Figuren 5 ff erläutert. Der in diesen Figuren dargestellte Hohlkörper 4 ist aus der in Figur 1 dargestellte Platine 9 gewickelt worden. Die Kante 17 bildet ein erstes Ende des Hohlkörpers 4, während die Kante 15 ein zweites Ende des Hohlkörpers 4 bildet.

In den Figuren 4 und 5 ist deutlich zu ersehen, dass sich die Kanten 11 und 13 der Platine 9 (siehe Figur 3) an dem Hohlkörper 4 gegenüberliegen. Sie sind nicht miteinander verschweißt, so dass sich die anhand der Figur 3 beschriebenen Änderungen (Querkraftkraft, Biegemoment) in axialer Richtung des Hohlkörpers 4 an der durch die Kanten 11 und 13 gebildeten ersten Fuge 31 einstellen.

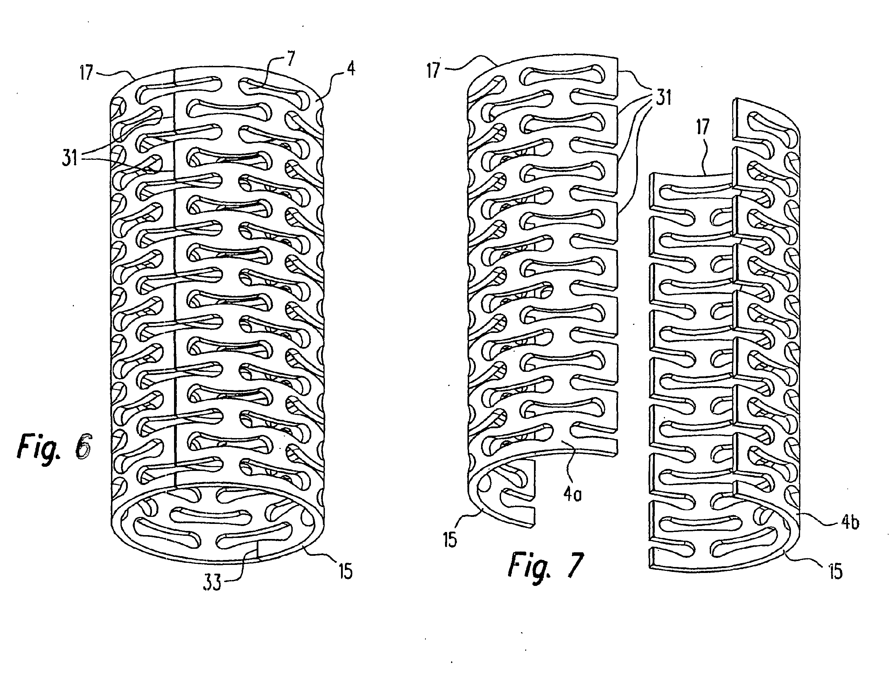

Erfindungsgemäß wird nun vorgesehen, in dem Hohlkörper 4 um 180 ° zur ersten Fuge 31 versetzt eine oder zwei zweite Fugen 33 vorzusehen (siehe Fig. 5 und 6). Dabei sind die zweiten Fugen 33 bei den Ausführungsbeispielen gemäß Figuren 5 und 6 nur so lang, dass sie eine Ausnehmung 7 erreichen. Dadurch wird der Hohlkörper 4 bei einem Umfangswinkel ϕ = 180 ° ebenfalls geschwächt und das Maximum 27 bei am Umfangswinkel ϕ = 180 ° verringert sich deutlich. Im Ergebnis führt diese Maßnahme dazu, dass die von dem Hohlkörper 4 auf den piezoelektrischen Aktor 1, 79 ausgeübte Federkraft ausschließlich in axialer Richtung verläuft. Biegemomente oder Kräfte in radialer Richtung werden nicht in den piezoelektrischen Aktor 1, 79 eingeleitet.

In Figur 6 ist ein zweites Ausführungsbeispiel eines erfindungsgemäßen Hohlkörpers dargestellt. Der wesentliche Unterschied besteht darin, dass eine ungerade Anzahl von Reihen von Ausnehmungen 7, nämlich 17, vorgesehen sind. Deshalb ist der Abschluss der ersten Fuge 31 an der Kante 17 und an der Kante 15 gleich. Dadurch ist der Kraftverlauf an der Kante 15 und an der Kante 17 gleich und entspricht dem in Figur 3 im Zusammenhang mit der Kante 17 dargestellten Kraftverlauf. Da der Kraftverlauf an beiden Enden 15 und 17 des Hohlkörpers 4 symmetrisch ist, wird das Federverhalten des erfindungsgemäßen Hohlkörpers 4 weiter verbessert. Die 17 Reihen von Ausnehmungen 7, die in Figur 6 nicht einzeln bezeichnet sind, bilden 17 Ebenen E₁ bis E₁₇, welche senkrecht zur Längsachse 35 des Hohlkörpers 4 verlaufen.

Bei dem Ausführungsbeispiel gemäß Figur 7 erstreckt sich die zweite Fuge 33 von der Kante 17 bis zur Kante 15 ausgeführt, so dass der Hohlkörper 4 aus zwei zylindrischen Halbschalen 4a und 4b besteht. Dadurch wird die zwischen den Kanten 17 und 15 und der oberen Abdeckplatte 6 sowie der unteren Abdeckplatte 5 (nicht dargestellt) über den Umfang übertragbare Kraft weiter vergleichmäßigt.

In Figur 8 ist ein mit einem Hohlkörper gemäß Figur 6 oder 7 ausgerüstete Aktoreinheit stark vereinfacht im Teillängsschnitt dargestellt. Damit der Hohlkörper 4, von dem nur die eine Hälfte 4a im Schnitt dargestellt ist, in radialer Richtung fixiert ist, weist die obere Abdeckplatte 6 einen Absatz 37 auf. Durch diesen Absatz 37 wird der Hohlkörper 4 radial fixiert. In der unteren Abdeckplatte 5 ist zur radialen Fixierung des Hohlkörpers 4 eine Ringnut 39 vorgesehen. Selbstverständlich kann auch in der oberen Abdeckplatte 6 eine Ringnut (nicht dargestellt) vorgesehen werden. Bei der in Fig. 8 dargestellten Aktoreinheit können nicht nur zweiteilige Hohlkörper 4, sondern auch andere erfindungsgemäße Hohlkörper, wie sie z. B. in den Figuren 3 bis 6 dargestellt sind, eingebaut werden.

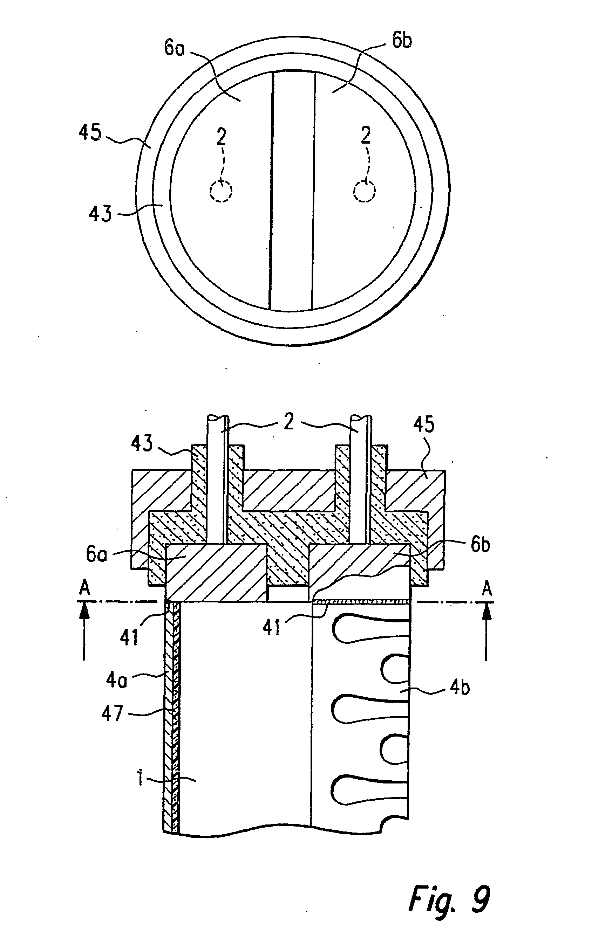

In Figur 9 ist ein weiteres Ausführungsbeispiel einer erfindungsgemäßen Aktoreinheit, welche mit einem zweiteiligen Hohlkörper 4 ausgerüstet ist, im Teillängsschnitt sowie in einer Ansicht von oben dargestellt. Bei diesem Ausführungsbeispiel ist auch die obere Abdeckplatte 6 zweiteilig ausgeführt. Die beiden Teile der oberen Abdeckplatte 6 sind in Figur 9 mit 6a und 6b bezeichnet. Je einer der beiden Kontaktstifte 2 sind mit je einem Teil 6a, 6b der oberen Abdeckplatte 6 elektrisch leitend verbunden. Über die obere Abdeckplatte 6a und 6b wird der Aktor 1 elektrisch angeschlossen. Die Details der elektrischen Verbindung zwischen Aktor 1 und den Teilen 6a und 6b der oberen Abdeckplatte sind in Figur 9 nicht dargestellt. Allerdings ist es einem Fachmann auf dem Gebiet der Konstruktion und der Fertigung von elektrischen Aktoren geläufig, wie eine solche Kontaktierung vorgenommen wird. Bei dem in Figur 9 dargestellten Ausführungsbeispiel ist der Teil 4a des Hohlkörpers 4 mit dem Teil 6a der oberen Abdeckplatte verschweißt, was durch eine stilisierte Schweißnaht 41 angedeutet ist. Ebenso ist der Teil 4b des Hohlkörpers mit dem Teil 6b der oberen Abdeckplatte 6 durch eine Schweißnaht 41 verbunden. Die Schweißnaht 41 übernimmt auch die radiale Fixierung des Hohlkörpers 4a, 4b.

Zwischen den Teilen 6a und 6b der oberen Abdeckplatte ist ein Isolator 43, welcher bevorzugt aus Keramik hergestellt wird, vorgesehen, um die Kontaktstifte 2 sowie die Teile 6a und 6b der oberen Abdeckplatte 6 elektrisch voneinander zu trennen. Des Weiteren ist bei dem Ausführungsbeispiel gemäß Figur 9 noch eine Sicherungsspange 45 vorgesehen, welche für den Zusammenhalt von Isolator 43 sowie der Teile 6a und 6b der oberen Abdeckplatte sorgt.

Zwischen dem Hohlkörper 4a, 4b und dem Aktor 1 ist ein flexibles Bindemittel 47 vorhanden, welches bevorzugt aus kunststoffgebundenem Metall oder einem weichen Lot besteht.

In Figur 9 ist des Weiteren ein Schnitt durch die erfindungsgemäße Aktoreinheit entlang der Linie A-A dargestellt.

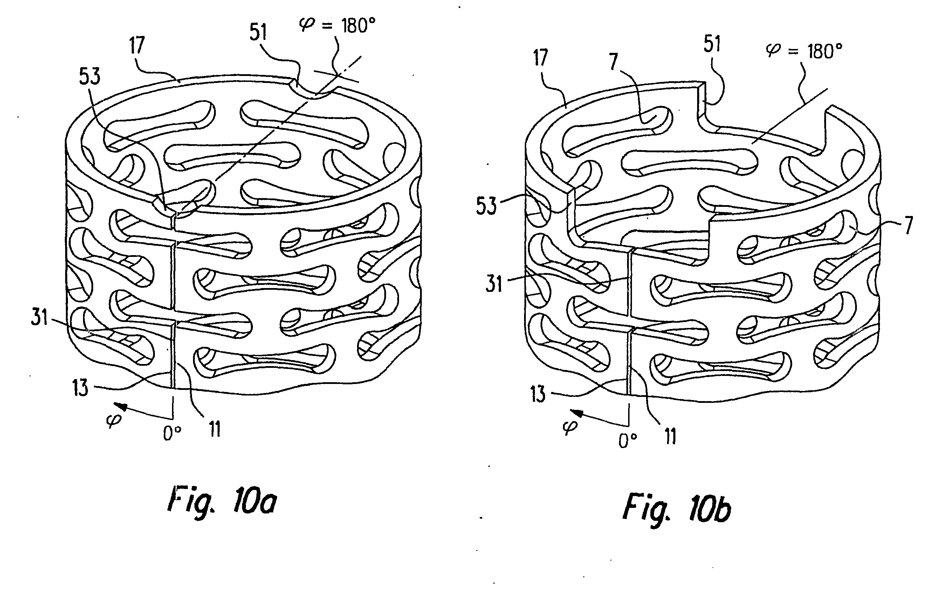

In Figur 10 a und Figur 10b werden zwei weitere Ausführungsformen erfindungsgemäßer Hohlkörper 4 perspektivisch dargestellt. Bei diesen Ausführungsformen wird, anders als bei den zuvor beschriebenen Ausführungsformen, eine Vermeidung der Querkraft des Hohlkörpers auf der der ersten Fuge 31 gegenüberliegenden Seite (ϕ ungefähr gleich 180 °) dadurch erreicht, dass dort eine Aussparung 51 vorgesehen wird. Die Aussparung 51 führt zu einer gezielten Schwächung des Hohlkörpers 4 an der der ersten Fuge 31 gegenüberliegenden Seite, so dass im Ergebnis der Hohlkörper 4 eine ausschließlich in axialer Richtung auf den piezoelektrischen Aktor 1, 79 ausübt. Der einzige Unterschied zwischen den Ausführungsformen gemäß Figur 10a und 10b liegt in der Form der Aussparungen 51. Bei der Ausführungsform gemäß Figur 10a hat die Aussparung 51 die Form eines Kreissegments, während bei der Ausführungsform gemäß Figur 10b die Aussparung 51 rechteckig ausgeführt. Die genaue Festlegung der Form der Aussparungen 51 und der Dimensionierung kann von einem Fachmann auf dem Gebiet der FEM-Berechnung ohne weiteres für jeden Anwendungsfall festgelegt werden.

In manchen Fällen hat es sich als vorteilhaft erwiesen, wenn auch im Bereich der ersten Fuge 31 Aussparungen 53 vorgesehen sind.

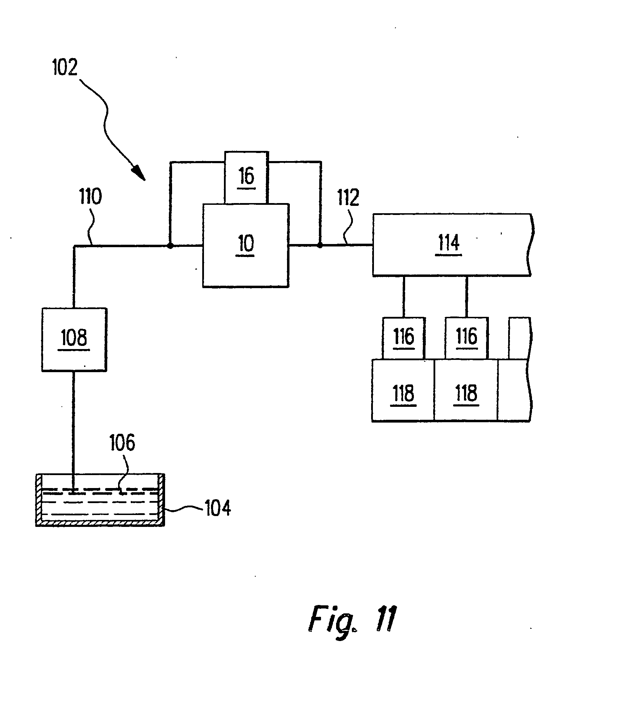

Die in den Figuren 10a und 10b nicht dargestellten ersten Enden 15 des Hohlkörpers 4 können gleich wie die zweiten Enden 17 ausgeführt werden.
Anhand der Figur 11 wird nachfolgend erläutert, wie das erfindungsgemäße Kraftstoffeinspritzventil 116 in eine Kraftstoffeinspritzanläge 102 einer Brennkraftmaschine integriert ist. Die Kraftstoffeinspritzanlage 102 umfasst einen Kraftstoffbehälter 104, aus dem Kraftstoff 106 durch eine elektrische oder mechanische Kraftstoffpumpe 108 gefördert wird. Über eine Niederdruck-Kraftstoffleitung 110 wird der Kraftstoff 106 zu einer Hochdruck-Kraftstoffpumpe 111 gefördert. Von der Hochdruck-Kraftstoffpumpe 111 gelangt der Kraftstoff 106 über eine Hochdruck-Kraftstoffleitung 112 zu einem Common-Rail 114. An dem Common-Rail sind mehrere Kraftstoffeinspritzventile 116 angeschlossen, die den Kraftstoff 106 direkt in Brennräume 118 einer nicht dargestellten Brennkraftmaschine einspritzen.

Es versteht sich von selbst, dass jedes der in der Beschreibung, den Zeichnungen oder den Patentansprüchen beschriebenen Merkmale einzeln oder in Kombination mit anderen Merkmalen erfindungswesentlich sein kann.

## Patentansprüche

1. Aktoreinheit mit einem in einem Hohlkörper (4) angeordneten piezoelektrischen Aktor (1), wobei der Hohlkörper (4) elastisch ausgebildet ist und den Aktor (1) vorspannt, und wobei der Hohlkörper (4) mit Ausnehmungen versehen ist und eine parallel zu einer Längsachse (35) verlaufende erste Fuge (31) aufweist, **dadurch gekennzeichnet, dass** mindestens an einem ersten Ende (17) des Hohlkörpers (4) eine der ersten Fuge (31) gegenüberliegend angeordnete zweite Fuge (33) vorgesehen ist.

2. Aktoreinheit nach Anspruch 1, **dadurch gekennzeichnet, dass** an einem zweiten Ende (15) des Hohlkörpers (4) eine der ersten Fuge (31) gegenüberliegend angeordnete zweite Fuge (33) vorgesehen ist.

3. Aktoreinheit nach Anspruch 2, **dadurch gekennzeichnet, dass** sich die zweite Fuge (33) von dem ersten Ende (17) bis zum zweiten Ende (15) des Hohlkörpers (4) erstreckt.

4. Aktoreinheit mit einem in einem Hohlkörper (4) angeordneten piezoelektrischen Aktor (1), wobei der Hohlkörper (4) elastisch ausgebildet ist und den Aktor (1) vorspannt, und wobei der Hohlkörper (4) mit Ausnehmungen (7) versehen ist und eine parallel zu einer Längsachse (35) verlaufende erste Fuge (31) aufweist, wobei der Hohlkörper (4) ein erstes Ende (17) aufweist, welches nicht durch Ausnehmungen (7) perforiert ist, **dadurch gekennzeichnet, dass** mindestens an dem ersten Ende (17) des Hohlkörpers (4) eine der ersten Fuge (31) gegenüberliegend angeordnete erste Aussparung (51) vorgesehen ist.

5. Aktoreinheit nach Anspruch 4, **dadurch gekennzeichnet, dass** an einem zweiten Ende (15) des Hohlkörpers (4) eine der ersten Fuge (31) gegenüberliegend angeordnete weitere Aussparung (51) vorgesehen ist.

6. Aktoreinheit nach Anspruch 4 oder 5, **dadurch gekennzeichnet, dass** am ersten Ende (17) und/oder am zweiten Ende (15) des Hohlkörpers (4) im Bereich der ersten Fuge (31) je eine Aussparung (53) vorgesehen ist.

7. Aktoreinheit nach einem der vorhergehenden Ansprüche, **dadurch gekennzeichnet, dass** der Hohlkörper (4) an seinem ersten Ende (17) mit einer oberen Abdeckplatte (6) oder einer Einstellscheibe (93) verbunden ist.

8. Aktoreinheit nach einem der vorhergehenden Ansprüche, **dadurch gekennzeichnet, dass** der Hohlkörper (4) an seinem ersten Ende (17) radial fixiert wird.

9. Aktoreinheit nach Anspruch 8, **dadurch gekennzeichnet, dass** der Hohlkörper (4) an seinem ersten Ende (17) radial in der oberen Abdeckplatte (6) oder in der Einstellscheibe (93), insbesondere durch eine Ringnut (39) oder einen Absatz (37), fixiert wird.

10. Aktoreinheit nach Anspruch 8, **dadurch gekennzeichnet, dass** der Hohlkörper (4) mit seinem ersten Ende (17) durch Schweissen (41) an der oberen Abdeckplatte (6) befestigt ist.

11. Aktoreinheit nach einem der Ansprüche 4 bis 10, **dadurch gekennzeichnet, dass** die Kontaktierung eines in dem Hohlkörper (4) befindlichen Piezo-Aktors (1) über die obere Abdeckplatte (6a, 6b) erfolgt.

12. Aktoreinheit nach einem der Ansprüche 4 bis 11, **dadurch gekennzeichnet, dass** die obere Abdeckplatte (6) zweiteilig ausgeführt ist, und dass zwischen den zwei Teilen (6, a, 6b) der oberen Abdeckplatte (6) eine Trennfuge vorhanden ist.

13. Aktoreinheit nach Anspruch 12, **dadurch gekennzeichnet, dass** die erste Fuge (31) und die zweite Fuge (33) in die Trennfuge der oberen Abdeckplatte (6a, 6b) münden.

14. Aktoreinheit nach einem der Ansprüche 11 bis 13, **dadurch gekennzeichnet, dass** die obere Abdeckplatte (6, 6a, 6b) durch einen Isolator (43), insbesondere einen Isolator aus Keramik, elektrisch isoliert wird.

15. Aktoreinheit nach einem der Ansprüche 11 bis 14, **dadurch gekennzeichnet, dass** die obere Abdeckplatte (6, 6a, 6b) durch eine Sicherungsklammer (45) oder einen Sicherungsdeckel zusammengehalten wird.

16. Aktoreinheit nach einem der Ansprüche 11 bis 15, **dadurch gekennzeichnet, dass** zwischen dem Hohlkörper (4) und dem Piezo-Aktor (1) ein flexibles Bindemittel (47), insbesondere kunststoffgebundenes Metall oder ein weiches Lot, vorhanden ist.

17. Aktoreinheit nach einem der vorhergehenden Ansprüche, **dadurch gekennzeichnet, dass** der Hohlkörper (4) an seinem zweiten Ende (15) radial fixiert wird.

18. Aktoreinheit nach einem der vorhergehenden Ansprüche, **dadurch gekennzeichnet, dass** der Hohlkörper (4) an seinem zweiten Ende (15) mit einer unteren Abdeckplatte (5) oder einem Kopplergehäuse (86) verbunden ist.

19. Aktoreinheit nach Anspruch 18, **dadurch gekennzeichnet, dass** der Hohlkörper (4) an seinem zweiten Ende (15) radial in der unteren Abdeckplatte(5) oder in dem Kopplergehäuse (86), insbesondere durch eine Ringnut (39) oder einen Absatz (91), fixiert wird.

20. Aktoreinheit nach Anspruch 18, **dadurch gekennzeichnet, dass** der Hohlkörper (4) mit seinem zweiten Ende (15) durch Schweissen (41) an der unteren Abdeckplatte (5) befestigt ist.

21. Aktoreinheit nach einem der vorhergehenden Ansprüche, **dadurch gekennzeichnet, dass** die Ausnehmungen (7) knochenförmig ausgebildet sind und quer zu einer Längsachse (35) des Hohlkörpers (4) verlaufen.

22. Aktoreinheit nach einem der vorhergehenden Ansprüche, **dadurch gekennzeichnet, dass** mehrere Ausnehmungen (7) in einer Ebene (E₂) hintereinander angeordnet sind, und dass die Ebene (E₂) mit der Längsachse (35) des Hohlkörpers (4) einen rechten Winkel bildet.

23. Aktoreinheit nach Anspruch 21, **dadurch gekennzeichnet, dass** eine gerade Zahl von Ausnehmungen (7) in einer Ebene (E₂) vorhanden ist.

24. Aktoreinheit nach einem der Ansprüche 22 oder 23, **dadurch gekennzeichnet, dass** mehrere Ebenen (Eᵢ) mit Ausnehmungen (7) vorgesehen sind, und dass die Ebenen (Eᵢ) parallel zueinander verlaufen.

25. Aktoreinheit nach einem der vorhergehenden Ansprüche, **dadurch gekennzeichnet, dass** die Ausnehmungen (7) zweier benachbarter Ebenen (E₁) zueinander versetzt (23) angeordnet sind.

26. Aktoreinheit nach Anspruch 25, **dadurch gekennzeichnet, dass** der Versatz (23) der Ausnehmungen (7) zweier benachbarter Ebenen gleich dem halben Rapport (21) der Ausnehmungen (7) einer Ebene (E₁) ist.

27. Aktoreinheit nach einem der vorhergehenden Ansprüche, **dadurch gekennzeichnet, dass** der Hohlkörper (4) einen kreisrunden Querschnitt hat.

28. Aktoreinheit nach einem der vorhergehenden Ansprüche, **dadurch gekennzeichnet, dass** der Querschnitt des Hohlkörpers (4) die Form eines regelmäßigen Vielecks hat.

29. Aktoreinheit nach einem der vorhergehenden Ansprüche, **dadurch gekennzeichnet, dass** der piezoelektrische Aktor (1) in dem Hohlkörper (4) angeordnet ist, und dass der piezoelektrische Aktor (1) durch den vorgespannten Hohlkörper (4) auf Druck belastet wird.

## Claims

1. Actuator unit having a piezoelectric actuator (1) which is arranged in a hollow body (4), with the hollow body (4) being elastic and prestressing the actuator (1), and with the hollow body (4) being provided with recesses and having a first joint (31) which runs parallel to a longitudinal axis (35), **characterized in that** a second joint (33) which is arranged opposite the first joint (31) is provided at least at a first end (17) of the hollow body (4).

2. Actuator unit according to Claim 1, **characterized in that** a second joint (33) which is arranged opposite the first joint (31) is provided at a second end (15) of the hollow body (4).

3. Actuator unit according to Claim 2, **characterized in that** the second joint (33) extends from the first end (17) to the second end (15) of the hollow body (4).

4. Actuator unit having a piezoelectric actuator (1) which is arranged in a hollow body (4), with the hollow body (4) being elastic and prestressing the actuator (1), and with the hollow body (4) being provided with recesses (7) and having a first joint (31) which runs parallel to a longitudinal axis (35), with the hollow body (4) having a first end (17) which is not perforated by recesses (7), **characterized in that** a first cutout (51) which is arranged opposite the first joint (31) is provided at least at the first end (17) of the hollow body (4).

5. Actuator unit according to Claim 4, **characterized in that** a further cutout (51) which is arranged opposite the first joint (31) is provided at a second end (15) of the hollow body (4).

6. Actuator unit according to Claim 4 or 5, **characterized in that** a cutout (53) is provided in the region of the first joint (31) at the first end (17) and/or at the second end (15) of the hollow body (4) in each case.

7. Actuator unit according to one of the preceding claims, **characterized in that**, at its first end (17), the hollow body (4) is connected to an upper covering plate (6) or a setting disc (93).

8. Actuator unit according to one of the preceding claims, **characterized in that** the hollow body (4) is radially fixed at its first end (17).

9. Actuator unit according to Claim 8, **characterized in that**, at its first end (17), the hollow body (4) is radially fixed in the upper covering plate (6) or in the setting disc (93), in particular by an annular groove (39) or a step (37).

10. Actuator unit according to Claim 8, **characterized in that** the first end (17) of the hollow body (4) is attached to the upper covering plate (6) by welds (41).

11. Actuator unit according to one of Claims 4 to 10, **characterized in that** contact is made with a piezo actuator (1) which is located in the hollow body (4) via the upper covering plate (6a, 6b).

12. Actuator unit according to one of Claims 4 to 11, **characterized in that** the upper covering plate (6) is of two-part design, and **in that** a parting joint is present between the two parts (6a, 6b) of the upper covering plate (6).

13. Actuator unit according to Claim 12, **characterized in that** the first joint (31) and the second joint (33) meet the parting joint of the upper covering plate (6a, 6b).

14. Actuator unit according to one of Claims 11 to 13, **characterized in that** the upper covering plate (6, 6a, 6b) is electrically insulated by an insulator (43), in particular a ceramic insulator.

15. Actuator unit according to one of Claims 11 to 14, **characterized in that** the upper covering plate (6, 6a, 6b) is held together by a securing clip (45) or a securing cover.

16. Actuator unit according to one of Claims 11 to 15, **characterized in that** a flexible binding means (47), in particular plastic-bound metal or a soft solder, is present between the hollow body (4) and the piezo actuator (1).

17. Actuator unit according to one of the preceding claims, **characterized in that** the hollow body (4) is radially fixed at its second end (15).

18. Actuator unit according to one of the preceding claims, **characterized in that**, at its second end (15), the hollow body (4) is connected to a lower covering plate (5) or a coupler housing (86).

19. Actuator unit according to Claim 18, **characterized in that**, at its second end (15), the hollow body (4) is radially fixed in the lower covering plate (5) or in the coupler housing (86), in particular by an annular groove (39) or a step (91).

20. Actuator unit according to Claim 18, **characterized in that** the second end (15) of the hollow body (4) is attached to the lower covering plate (5) by welds (41).

21. Actuator unit according to one of the preceding claims, **characterized in that** the recesses (7) are bone-like and run transverse to a longitudinal axis (35) of the hollow body (4).

22. Actuator unit according to one of the preceding claims, **characterized in that** a plurality of recesses (7) are arranged in series in one plane (E₂), and **in that** the plane (E₂) forms a right angle with the longitudinal axis (35) of the hollow body (4).

23. Actuator unit according to Claim 21, **characterized in that** an even number of recesses (7) are present in one plane (E₂).

24. Actuator unit according to either of Claims 22 and 23, **characterized in that** a plurality of planes (Eᵢ) are provided with recesses (7), and **in that** the planes (Eᵢ) run parallel to one another.

25. Actuator unit according to one of the preceding claims, **characterized in that** the recesses (7) of two adjacent planes (E₁) are arranged in a manner offset (23) in relation to one another.

26. Actuator unit according to Claim 25, **characterized in that** the offset (23) of the recesses (7) of two adjacent planes is equal to half the repeated pattern (21) of the recesses (7) of one plane (E₁).

27. Actuator unit according to one of the preceding claims, **characterized in that** the hollow body (4) has a circular cross section.

28. Actuator unit according to one of the preceding claims, **characterized in that** the cross section of the hollow body (4) has the shape of a regular polygon.

29. Actuator unit according to one of the preceding claims, **characterized in that** the piezoelectric actuator (1) is arranged in the hollow body (4), and **in that** the piezoelectric actuator (1) is subjected to compressive loading by the prestressed hollow body (4).

## Revendications

1. Unité actionneur comportant un actionneur piézoélectrique (1) disposé dans un corps creux (4), le corps creux (4) étant de conception élastique et précontraignant l'actionneur (1), le corps creux (4) étant pourvu de perforations et présentant une première jointure (31) parallèle à un axe longitudinal (35),
**caractérisée en ce qu'**
il est prévu au niveau d'une première extrémité (17) du corps creux (4) au moins une deuxième jointure (33) en regard de la première jointure (31).

2. Unité actionneur selon la revendication 1,
**caractérisée en ce qu'**
il est prévu au niveau d'une deuxième extrémité (15) du corps creux (4) une deuxième jointure (33) en regard de la première jointure (31).

3. Unité actionneur selon la revendication 2,
**caractérisée en ce que**
la deuxième jointure (33) s'étend de la première extrémité (17) à la deuxième extrémité (15) du corps creux (4).

4. Unité actionneur comportant un actionneur piézoélectrique (1) agencé dans un corps creux (4), le corps creux (4) étant de conception élastique et précontraignant l'actionneur (1), le corps creux (4) étant pourvu de perforations (7) et présentant une première jointure (31) parallèle à un axe longitudinal (35), le corps creux (4) présentant une première extrémité (17) qui n'est pas perforée par des perforations (7),
**caractérisée en ce qu'**
il est prévu au niveau de la première extrémité (17) du corps creux (4) au moins un premier évidement (51) en regard de la première jointure (31).

5. Unité actionneur selon la revendication 4,
**caractérisée en ce qu'**
il est prévu au niveau de la deuxième extrémité (15) du corps creux (4) un autre évidement (51) en regard de la première jointure (31).

6. Unité actionneur selon la revendication 4 ou 5,
**caractérisée en ce qu'**
il est prévu à chaque fois au niveau de la première extrémité (17) et/ ou de la deuxième extrémité (15) du corps creux (4), à proximité de la première jointure (31), un évidement (53).

7. Unité actionneur selon l'une des revendications précédentes,
**caractérisée en ce que**
le corps creux (4) est relié au niveau de sa première extrémité (17) à une plaque de recouvrement supérieure (6) ou à une rondelle de réglage (93).

8. Unité actionneur selon l'une des revendications précédentes,
**caractérisée en ce que**
le corps creux (4) est fixé radialement au niveau de sa première extrémité (17).

9. Unité actionneur selon la revendication 8,
**caractérisée en ce que**
le corps creux (4) est fixé radialement au niveau de sa première extrémité (17) dans la plaque de recouvrement supérieure (6), notamment au moyen d'une rainure annulaire (39) ou d'un épaulement (37).

10. Unité actionneur selon la revendication 8,
**caractérisée en ce que**
le corps creux (4) est fixé par sa première extrémité (17) à la plaque de recouvrement supérieure (6) par soudure (41).

11. Unité actionneur selon l'une des revendications 4 à 10,
**caractérisée en ce que**
le contact d'un actionneur piézoélectrique (1) se trouvant dans le corps creux (4) se produit par l'intermédiaire de la plaque de recouvrement supérieure (6a, 6b).

12. Unité actionneur selon l'une des revendications 4 à 11,
**caractérisée en ce que**
la plaque de recouvrement supérieure (6) se compose de deux pièces et il existe un plan de joint entre les deux pièces (6a, 6b) de la plaque de recouvrement supérieure (6).

13. Unité actionneur selon la revendication 12,
**caractérisée en ce que**
la première jointure (31) et la deuxième jointure (33) débouchent dans le plan de joint de la plaque de recouvrement supérieure (6a, 6b).

14. Unité actionneur selon l'une des revendications 11 à 13,
**caractérisée en ce que**
la plaque de recouvrement supérieure (6, 6a, 6b) est isolée électriquement par un isolateur (43), notamment un isolateur en céramique.

15. Unité actionneur selon l'une des revendications 11 à 14,
**caractérisée en ce que**
la plaque de recouvrement supérieure (6, 6a, 6b) est retenue au moyen d'une agrafe de sécurité (45) ou d'un couvercle de sécurité.

16. Unité actionneur selon l'une des revendications 11 à 15,
**caractérisée en ce qu'**
il existe un organe de liaison souple (47), notamment un métal à liant plastique ou une soudure à l'étain, entre le corps creux (4) et l'actionneur piézoélectrique (1).

17. Unité actionneur selon l'une des revendications précédentes,
**caractérisée en ce que**
le corps creux (4) est fixé radialement au niveau de sa deuxième extrémité (15).

18. Unité actionneur selon l'une des revendications précédentes,
**caractérisée en ce que**
le corps creux (4) est relié au niveau de sa deuxième extrémité (15) à une plaque de recouvrement inférieure (5) ou à un boîtier modulaire (86).

19. Unité actionneur selon la revendication 18,
**caractérisée en ce que**
le corps creux (4) est fixé radialement au niveau de sa deuxième extrémité (15) dans la plaque de recouvrement inférieure (5) ou le boîtier modulaire (86), notamment au moyen d'une rainure annulaire (39) ou d'un épaulement (91).

20. Unité actionneur selon la revendication 18,
**caractérisée en ce que**
le corps creux (4) est fixé par sa deuxième extrémité (15) à la plaque de recouvrement inférieure (5) par soudure (41).

21. Unité actionneur selon l'une des revendications précédentes,
**caractérisée en ce que**
les perforations (7) sont en forme d'os et sont dirigées transversalement à un axe longitudinal (35) du corps creux (4).

22. Unité actionneur selon l'une des revendications précédentes,
**caractérisée en ce que**
plusieurs perforations (7) sont agencées les unes derrière les autres dans un plan (E₂), et le plan (E₂) forme un angle droit avec l'axe longitudinal (35) du corps creux (4).

23. Unité actionneur selon la revendication 21,
**caractérisée en ce qu'**
il existe un nombre pair de perforations (7) dans un plan (E₂).

24. Unité actionneur selon l'une des revendications 22 ou 23,
**caractérisée par**
plusieurs plans (Eᵢ) comportant des perforations (7) et parallèles les uns aux autres.

25. Unité actionneur selon l'une des revendications précédentes,
**caractérisée en ce que**
les perforations (7) de deux plans (E₁) voisins sont décalées (23) les unes par rapport aux autres.

26. Unité actionneur selon la revendication 25,
**caractérisée en ce que**
le décalage (23) des perforations (7) de deux plans voisins est équivalent à la moitié du rapport (21) des perforations d'un plan (E₁).

27. Unité actionneur selon l'une des revendications précédentes,
**caractérisée en ce que**
le corps creux (4) présente une section transversale circulaire.

28. Unité actionneur selon l'une des revendications précédentes,
**caractérisée en ce que**
la section transversale du corps creux (4) a la forme d'un polygone régulier.

29. Unité actionneur selon l'une des revendications précédentes,
**caractérisée en ce que**
l'actionneur piézoélectrique (1) est agencé dans le corps creux (4), et l'actionneur piézoélectrique (1) est soumis à pression par le corps creux (4) précontraint.
